(19) Europäisches Patentamt

European Patent Office

Office européen des brevets

(11) **EP 1 030 440 A1**

(12) **EUROPÄISCHE PATENTANMELDUNG**

(43) Veröffentlichungstag:
23.08.2000 Patentblatt 2000/34

(51) Int. Cl.[7]: **H03D 7/16**, G01S 7/40

(21) Anmeldenummer: **00102493.4**

(22) Anmeldetag: **05.02.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **16.02.1999 DE 19906314**

(71) Anmelder:
**DLR Deutsches Zentrum für Luft- und Raumfahrt e.V.
53175 Bonn (DE)**

(72) Erfinder:
- **Bauer, Robert
  80636 München (DE)**
- **Waegel, Karl-Hans
  82205 Gilching (DE)**
- **Hounam, David, Dr.
  82234 Wessling (DE)**

(74) Vertreter:
**von Kirschbaum, Albrecht, Dipl.-Ing.
Patentanwalt, Bahnhofplatz 2
82102 Germering (DE)**

(54) **Einrichtung zur Umkehr eines Einseitenbandes mit einem Träger**

(57) Zur Einseitenbandumsetzung mit einem einzigen Trägeroszillator (8) wird unter Verwendung eines Quadraturdemodulators das HF-Eingangssignal in das Basisband heruntergemischt. Inphase- und Quadraturkomponente werden durch Tiefpaßfilter (3a, 3b) gefiltert. Die erhaltenen Basisband-Komponenten sind um 90° phasenverschoben.

Ein Quadraturmodulator setzt die Basisband-Komponenten wieder in die HF-Ebene um. An den Ausgängen von zwei Mischern (4a, 4b) liegen sowohl Signale der Regel- und Kehrlage an. An einem Mischerausgang wird bei einer Signalkomponente eine Vorzeichenumkehr vorgenommen, die zur Kompensation genutzt werden kann. Somit ist eine Seitenbandumkehr erfolgt.

**EP 1 030 440 A1**

**Beschreibung**

Die Erfindung betrifft Einrichtungen zur Umkehr eines Einseitenbandes mit nur einem Träger.

Bei einem Transponder, der ein empfangenes Signal auf gleicher Frequenz seitenbandinvertiert wieder abstrahlen soll, sind bisher zwei Trägeroszillatoren notwendig, für welche gilt: (ft1=fs-fzf) und (ft2=fs+fzf), wobei mit ft1 und ft2 Trägerfrequenzen, mit fs die Signalfrequenz und mit fzf die Zwischenfrequenz bezeichnet sind. Weitere Einsatzmöglichkeiten sind u.a. Testsignalgeneratoren sowie allgemeine Signalverarbeitungsbaugruppen.

Ein von der Anmelderin entwickelter und betriebener, kodierender Transponder für Synthetik-Apertur-Radar (SAR) wird zur Markierung von Radarzielen eingesetzt. Hierzu werden von einem Satelliten (z.B. ERS 2) abgestrahlte, frequenzmodulierte Pulse mit speziellen Codes moduliert, die nach entsprechender Prozessierung der Bilddaten eine eindeutige Lokalisierung und Identifizierung des mit einem Transponder ausgestatteten Zieles ermöglichen.

Um ein zusätzliches Unterscheidungskriterium für Ziele zu schaffen, wird eine Seitenbandumkehr des frequenzmodulierten Pulses vorgenommen. Hierzu ist ein hoher Aufwand nötig, da zwei Lokaloszillatoren eingesetzt werden und eine Umsetzung auf eine Zwischenfrequenz erfolgen muß. Dies bedingt im allgemeinen eine Leistungsaufnahme, die für batteriebetriebene Geräte zu hoch ist.

Aus DE 43 40 722 C1 ist ein Verfahren zum sendeseitigen Unterdrücken eines per Modulation entstehenden Restträgers bekannt, wobei ein Trägereingangssignal in einem Richtkoppler in zwei Zweige aufgeteilt wird. Hierbei wird in einem Zweig der eine Teil des Trägersignals an einem 90°-Eingang eines IQ-Modulators angelegt, an dessen Mischer um 90° gegeneinander phasenverschobene Basisbänder angelegt sind. In einem anderen Zweig wird der verbleibende Trägersignalanteil um 180° gedreht an einen Eingang eines Leistungskombinierers angelegt; dessen anderen Eingang wird das Ausgangssignal des IQ-Modulators zugeführt. Dadurch ist das am Ausgangssignal des IQ-Modulators erhaltene Trägerrestsignal unterdrückt.

Ferner ist aus DE 40 38 405 A1 ein Verfahren zum Aussieben eines unteren oder oberen Seitenbandes aus einer Zweiseitenbandschwingung bekannt, bei welchem ein Seitenband der Seitenbandschwingung mit gleicher Amplitude, aber entgegengesetzten Vorzeichen mit dem anderen Seitenband gemischt wird.

Aufgabe der Erfindung ist es, die Umkehr eines Einseitenbandes schaltungstechnisch erheblich zu vereinfachen. Gemäß der Erfindung ist die Aufgabe durch die Merkmale in einem der Ansprüche 1 bis 4 gelöst.

Bei der Erfindung wird das Empfangssignal ins Basisband unter Aufteilung in Inphase- und Quadraturkomponenten gemischt. Die Basisbandkomponenten werden nach einer Tiefpaßfilterung mittels eines Quadraturmodulators wieder in die HF-Ebene umgesetzt. Dadurch kann gemäß der Erfindung eine Seitenbandumkehr vorgenommen werden.

Statt auf eine Zwischenfrequenz herunterzumischen, bei der Signaldetektion und Pulsumtastung erfolgen, und wieder hochzumischen, wird somit gemäß der Erfindung ein HF-Eingangssignal auf die Basisbandebene gemischt, bei der die Detektion und Seitenbandumkehr erfolgen. Die Pulsumtastung erfolgt dann auf der HF-Ebene; hierfür ist nur ein Lokaloszillator erforderlich. Da bisher bei einer Seitenbandumkehr die Frequenz von zwei Umsetzoszillatoren für eine Prozessierung von Radardaten bekannt sein mußte, ist gemäß der Erfindung, bei der nur ein einziger Oszillator benötigt wird, der Aufwand zur Frequenzmessung und -stabilisierung erheblich geringer.

Nachfolgend wird die Erfindung unter Bezugnahme auf die Zeichnungen anhand von Ausführungsformen im einzelnen beschrieben. Es zeigen:

Fig.1 und 2   Ausführungsformen von zwei grundlegenden, schematischen Schaltungsanordnungen, und

Fig.3 und 4   Varianten der in Fig.1 und 2 dargestellten Schaltungsanordnungen.

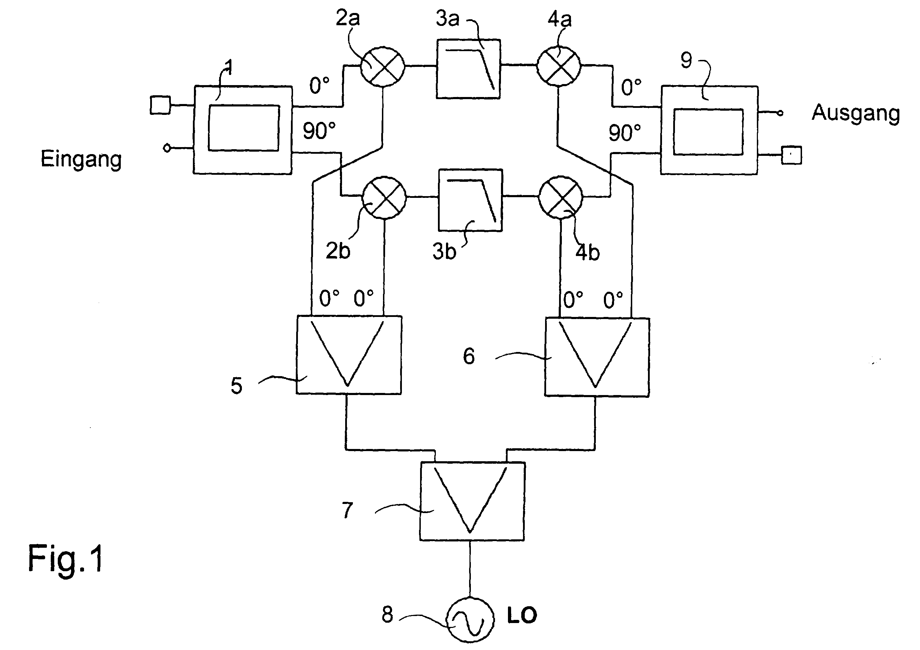

In Fig.1 ist eine Ausführungsform einer ersten Schaltungsanordnung dargestellt. Ein HF-Eingangssignal wird über ein 90°-Hybrid 1 in Inphase- und Quadraturkomponenten aufgeteilt. In nachgeordneten Mischern 2a und 2b wird das Signal auf die Basisbandebene umgesetzt. An den Mischerausgängen liegen zwei um 90° phasenverschobene, um die Mittenfrequenz 0 „gefaltete" Basisbandsignale an; hierzu wird von einem Lokaloszillator 8 in beide Mischer 2a und 2b gleichphasig über Leistungsteiler 7 und 5 eingespeist.

Somit liegen sowohl das obere als auch das untere Seitenband an beiden Mischerausgängen an Tiefpaßfiltern 3a,3b an, deren Grenzfrequenz bei der halben Bandbreite des Nutzsignalbereichs liegt. Anschließend findet über weitere Mischer 4a und 4b eine Umsetzung in die HF-Ebene statt, wobei die Einspeisung vom Lokal-Oszillator 8 über Leistungsverteiler 6 und 7 gleichphasig erfolgt.

Nachdem ein Mischer bei hinreichend kleiner Eingangssignalamplitude als Analogmultiplizierer betrachtet werden kann, ergeben sich folgende Beziehungen:

$$\cos(\omega t + \omega s)\sin \omega t = \tfrac{1}{2}[\sin(-\omega s) + \sin(2\omega t + \omega s)] \quad (1)$$

$$\sin(\omega t + \omega s)\sin \omega t = \tfrac{1}{2}[\cos(-\omega s) + \cos(2\omega t + \omega s)] \quad (2)$$

Hierbei sind mit $\omega s$ ein Signalfrequenz (Basisband) und mit $\omega t$ die Trägerfrequenz bezeichnet.

Die am Ausgang des Hybrids 1 anliegenden Signale ($\omega t+\omega s$) sind um 90° phasenverschoben. Durch Mischen mit gleichphasigen Signalen $\omega t$ entstehen die in Gl. (1) (In-Phase-Zweig) und in Gl. (2) (Quadraturzweig) angegebenen Mischprodukte in Form von Summen- bzw. Differenzfrequenzen.

Durch die Tiefpaßfilter 3a und 3b werden die Summenfrequenzen ($2\omega t+\omega s$) ausgefiltert.

Somit ergibt sich für einen aufwärtsmischenden Quadraturmodulator:

$$\tfrac{1}{2} \sin(-\omega s)\sin \omega t = \tfrac{1}{4}[\cos(\omega t+\omega s)-\cos(\omega t-\omega s)] \quad (3)$$

$$\tfrac{1}{2} \cos(-\omega s)\sin \omega t = \tfrac{1}{4}[\sin(\omega t+\omega s)+\sin(\omega t-\omega s)] \quad (4)$$

Die Gl.(3) und (4) beschreiben die Ausgangssignale der Mischer 4a und 4b. Hierbei stellen die Summenprodukte ($\omega t+\omega s$) das Signal in Regellage und die Differenzprodukte ($\omega t-\omega s$)das Signal in Kehrlage dar.

Somit ergeben sich zwei Möglichkeiten. Wenn die Mischprodukte in Gl.(4) um 90° phasenverzögert werden, entfallen bei anschließender Addition in einem Hybrid 9 die Summenterme ($\omega t+\omega s$), was der Regellage enstpricht. Die Kehrlagenterme ($\omega t-\omega s$) addieren sich.

Bei einer Phasenverzögerung um 90° der Mischprodukte in Gl.(3) addieren sich die Terme der Regellage und die Kehrlagenterme löschen sich aus. Hierbei ist eine Vertauschung der Ausgänge der Tiefpaßfilter 3a, 3b die einfachste Umschaltmöglichkeit.

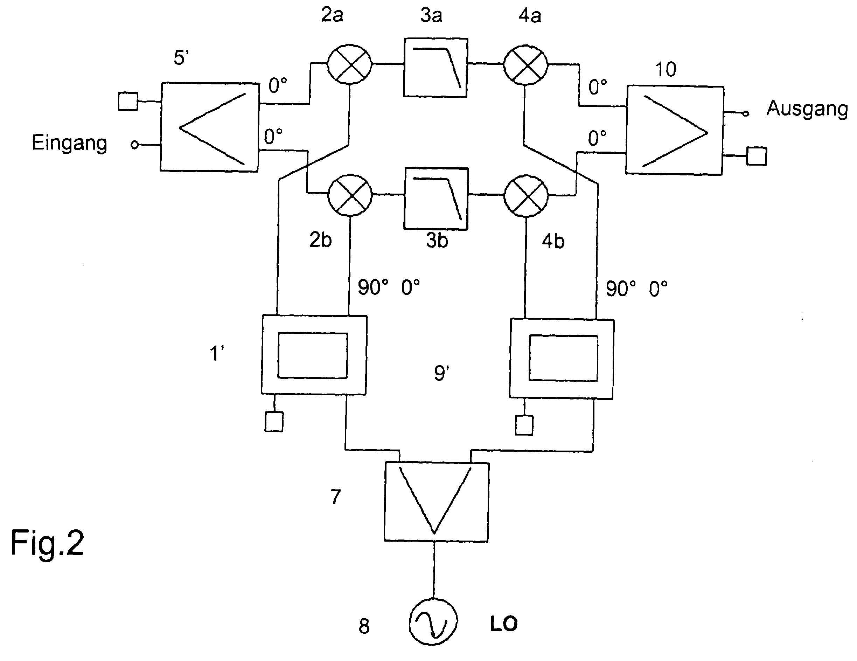

In Fig.2 ist eine zweite Schaltungsanordnung dargestellt.

In der Schaltungsanordnung der Fig.2 wird ein HF-Eingangssignal gleichphasig mittels eines Leistungsteilers 1 auf zwei Mischer 2a, 2b aufgeteilt. Die Mischer 2a, 2b werden von einem 90°-Hybrid 1' mit phasenverschobenen Signalen des Lokal-Oszillators gespeist, wodurch die HF-Komponenten in das Basisband umgesetzt werden.

Dadurch ergeben sich die in Gl'en(5) und (6) angegebenen Beziehungen:

$$\sin(\omega t+\omega s).\sin \omega t = \tfrac{1}{2}[\cos \omega s-\cos(2\omega t+\omega s)] \quad (5)$$

$$\sin(\omega t+\omega s).\cos \omega t = \tfrac{1}{2}[\sin \omega s+\cos(2\omega t+\omega s)] \quad (6)$$

Analog zu Gl.(3) und Gl.(4) stellen Gl.(5) und Gl.(6) die Mischprodukte der zweiten Variante dar, die an den Mischern 2a, 2b anliegen. Durch Filterung in den Tiefpaßfiltern 3a, 3b werden wieder die Summenterme eliminiert.

Die Mischprodukte des Quadraturaufwärtsmischers lauten nun:

$$\tfrac{1}{2} \cos \omega s \cos \omega t = \tfrac{1}{4}[\cos(\omega t-\omega s)+\cos(\omega t+\omega s)] \quad (7)$$

$$\tfrac{1}{2} \sin \omega s \sin \omega t = \tfrac{1}{4}[\cos(\omega t-\omega s)-\sin(\omega t+\omega s)] \quad (8)$$

Nach gleichphasiger Addition beider Terme durch einen Leistungssummierer 10 ergibt sich der Wegfall des Signalanteils der Regellage ($\omega t+\omega s$) und als Ausgangsprodukt die Kehrlage($\omega t-\omega s$).

Ebenso ist eine Kombination von den in den Fig.1 und Fig.2 dargestellten Schaltungsanordnungen möglich, wenn unter Bezug auf Fig.2 ein 90° Hybrid 1' mit dem gleichphasigen Leistungsteiler 5' vertauscht wird .

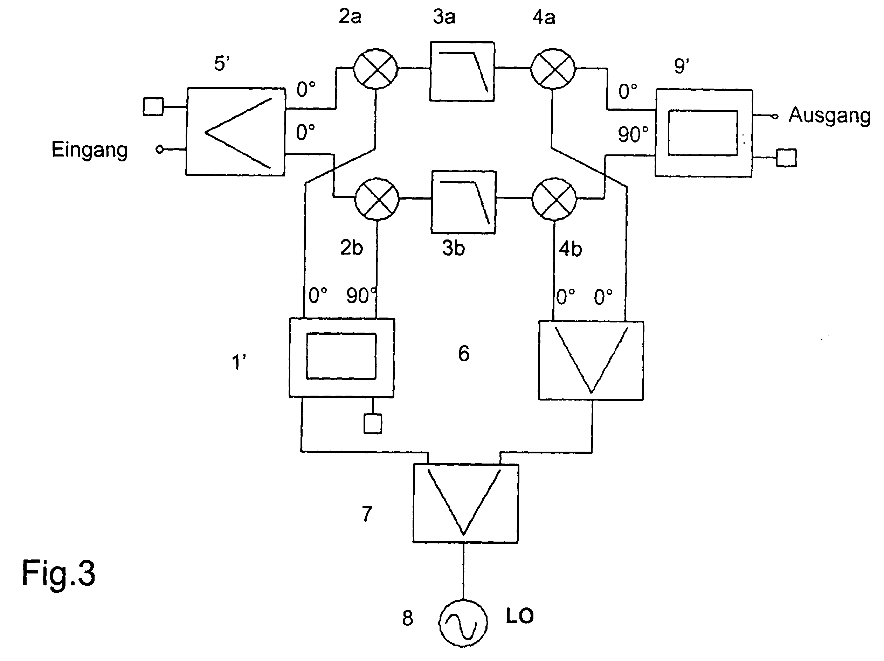

In Fig.3 ist eine dritte Schaltungsanordnung dargestellt, bei der eine Kombination der in Fig.1 und Fig.2 angewandten Signalverarbeitungskomponenten benutzt wird.

Dabei ergeben sich folgende Beziehungen:

$$\sin(\omega t+\omega s). \cos \omega t = \tfrac{1}{2}[\sin \omega s+\cos(2\omega t+\omega s)] \quad (9)$$

$$\sin(\omega t+\omega s). \sin \omega t = \tfrac{1}{2}[\sin \omega s-\cos(2\omega t+\omega s)] \quad (10)$$

Daraus folgt:

$$\tfrac{1}{2} \sin \omega t \sin \omega s = \tfrac{1}{4}[\cos(\omega t-\omega s)-\cos(\omega t+\omega s)] \quad (11)$$

$$\tfrac{1}{2} \sin \omega t \cos \omega s = \tfrac{1}{4}[\sin(\omega t-\omega s)+\sin(\omega t+\omega s)] \quad (12)$$

Eine Phasenverzögerung des Mischerausgangsprodukts des Quadraturzweiges (Gl.12) bewirkt eine Auslöschung des Regellagesignals.

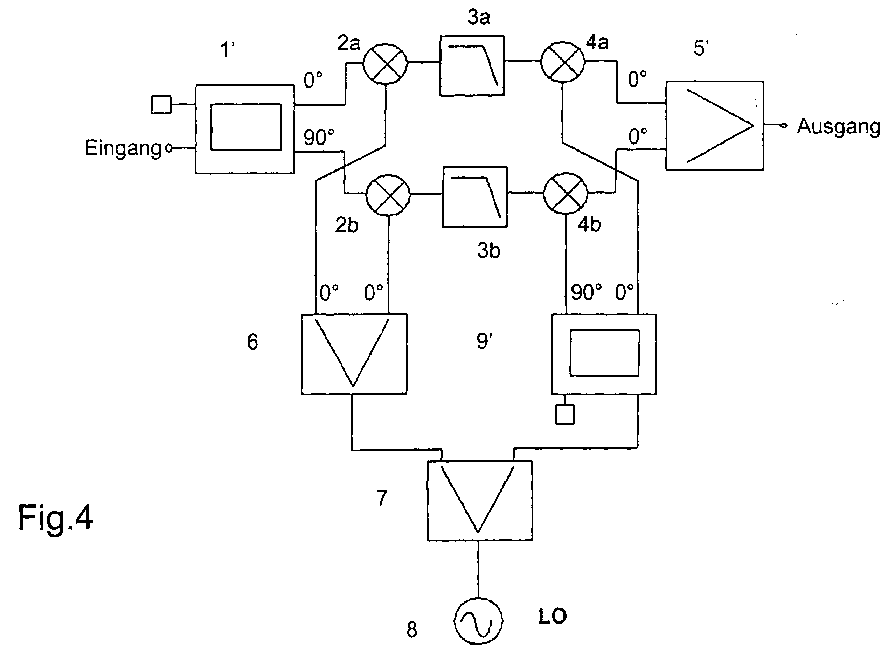

In Fig.4 ist eine vierte Schaltungsanordnung dargestellt, die lediglich eine spiegelbildliche Anordnung der in Fig.3 dargestellten Schaltungsanordnung ist. Aus diesem Grund erübrigt sich sowohl eine mathematische Herleitung als auch eine spezielle Beschreibung der Schaltungsanordnung in Fig.4.

Bezugszeichenliste

| | |
|---|---|
| 1, 1' | 90°-Hybrid |
| 2a, 2b | Mischer |
| 3a, 3b | Tiefpaßfilter |
| 4a, 4b | Mischer |
| 5, 5', 6, 7 | Leistungsteiler |
| 8 | Lokaloszillator |
| 9, 9' | 90°-Hybrid |
| 10 | Leistungssummierer |

**Patentansprüche**

1. Einrichtung zur Umkehr eines Einseitenbandes mit einem Träger, dadurch **gekennzeichnet**, daß

ein HF-Eingangssignal mittels eines 90° - Hybrids (1) in Inphase- und Quadraturkomponenten aufgeteilt wird;
die beiden HF-Komponenten in Mischern (2a, 2b) mit einem gleichphasig eingespeisten Träger ins Basisband gemischt werden;

die erhaltenen Signalmischprodukte durch Tiefpaßfilter (3a, 3b), deren Grenzfrequenz bei der halben umzusetzenden Basisbandbreite liegt, eliminiert werden;

an den Ausgängen der Tiefpaßfilter (3a,3b) anliegende, um 90° phasenversetzte Basisbandsignal-Komponenten durch weitere Mischer (4a, 4b), die mit gleichphasigen Trägersignalen gespeist werden, wieder in die HF-Ebene umgesetzt werden, so daß an den Ausgängen der beiden Mischer (4a, 4b) Signale sowohl in Regellage- als auch in Kehrlage anliegen, und

durch eine Phasenverschiebung des Ausgangssignals im Quadraturzweig um 90° und durch eine anschließende Addition am Ausgang ein Signal in Kehrlage erhalten wird.

2. Einrichtung zur Umkehr eines Einseitenbandes mit einem Träger, dadurch **gekennzeichnet**, daß

ein HF-Eingangssignal gleichphasig auf zwei Mischer (2a, 2b) aufgeteilt wird;

die HF-Komponenten mit um 90° phasenverschobenen Trägern ins Basisband gemischt werden;

die erhaltenen Summenmischprodukte durch Tiefpaßfilter (3a, 3b), deren Grenzfrequenz bei der halben umzusetzenden Basisbandbreite liegt, eliminiert werden;

an den Ausgängen der Tiefpaßfilter (3a, 3b) anliegende, um 90° phasenversetzte Basisbandsignale-Komponenten durch weitere Mischer (4a, 4b),die mit um 90° phasenversetzten Trägersignalen gespeist werden, wieder in die HF-Ebene umgesetzt werden, und

durch eine anschließende Addition die Signalkomponente in Regellage eliminiert wird und am Ausgang nur ein Signal in Kehrlage erhalten wird.

3. Einrichtung zur Umkehr eines Einseitenbandes mit einem Träger, dadurch **gekennzeichnet**, daß

ein HF-Eingangssignal gleichphasig auf zwei Mischer (2a, 2b) aufgeteilt wird;

die HF-Komponenten mit um 90° phasenverschobenen Trägern ins Basisband gemischt werden;

die erhaltenen Summenmischprodukte durch Tiefpaßfilter (3a, 3b), deren Grenzfrequenz bei der halben umzusetzenden Basisbandbreite liegt, eliminiert werden;

an den Ausgängen der Tiefpaßfilter (3a, 3b) anliegende, um 90° phasenversetzte Basisbandsigal-Komponenten durch weitere Mischer (4a, 4b), die mit gleichphasigen Trägersignalen gespeist werden, wieder in die HF-Ebene umgesetzt werden, so daß an den Ausgängen der beiden Mischer (4a, 4b) Signale sowohl in Regellage als auch Kehrlage anliegen, und

durch eine Phasenverschiebung des Ausgangssignals im Quadraturzweig um 90° und durch eine entsprechende Addition die Signalkomponente der Regellage eliminiert und am Ausgang ein Signal in Kehrlage erhalten wird.

4. Einrichtung zur Umkehr eines Einseitenbandes mit einem Träger, dadurch **gekennzeichnet**, daß

ein HF-Eingangssignal mittels eines 90° - Hybrids (1) in Inphase- und Quadraturkomponenten aufgeteilt wird;

die beiden HF-Komponenten mit einem gleichphasig eingespeisten Träger ins Basisband gemischt werden;

die erhaltenen Summenmischprodukte durch Tiefpaßfilter (3a, 3b), deren Grenzfrequenz bei der halben umzusetzenden Basisbandbreite liegt, eliminiert werden, wodurch an den Ausgängen der Tiefpaßfilter (3a, 3b) anliegende, um 90° phasenversetzte Basisband-Komponenten durch weitere Mischer (4a, 4b), die mit um 90° phasenversetzten Trägersignalen gespeist werden, wieder in die HF-Ebene umgesetzt werden, und

durch eine entsprechende Addition die Signalkomponente der Regellage eliminiert wird und am Ausgangssignal ein Signal in Kehrlage erhalten wird.

Fig.1

EP 1 030 440 A1

Fig.2

EP 1 030 440 A1

Fig.3

2a   3a   4a

5'

Eingang

0°
0°

2b   3b   4b

0°   90°   0°   0°

1'

6

7

8   LO

9'

Ausgang

0°
90°

EP 1 030 440 A1

Fig.4

EP 1 030 440 A1

EP 1 030 440 A1

Europäisches Patentamt

**EUROPÄISCHER RECHERCHENBERICHT**

Nummer der Anmeldung

EP 00 10 2493

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | GB 2 236 225 A (EMI PLC THORN) 27. März 1991 (1991-03-27) * Seite 3, Zeile 21 - Seite 6, Zeile 18 * * Seite 8, Zeile 21 - Seite 9, Zeile 2 * --- | 1-4 | H03D7/16 G01S7/40 |
| X | US 4 193 035 A (BERGER HERMANN) 11. März 1980 (1980-03-11) * Spalte 3, Zeile 37 - Spalte 6, Zeile 68 * --- | 1-4 | |
| X | US 4 607 229 A (ISOBE SEIJI ET AL) 19. August 1986 (1986-08-19) * das ganze Dokument * --- | 1-4 | |
| X | US 4 394 626 A (KURIHARA HIROSHI ET AL) 19. Juli 1983 (1983-07-19) * Spalte 3, Zeile 35 - Spalte 5, Zeile 25 * --- | 1-4 | |
| A | DE 196 20 682 A (DEUTSCHE FORSCH LUFT RAUMFAHRT) 28. November 1996 (1996-11-28) ----- | | |

| RECHERCHIERTE SACHGEBIETE (Int.Cl.7) |
|---|
| H03D G01S |

Der vorliegende Recherchenbericht wurde für alle Patentansprüche erstellt

| Recherchenort | Abschlußdatum der Recherche | Prüfer |
|---|---|---|
| MÜNCHEN | 17. Mai 2000 | Kahn, K-D |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 00 10 2493

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-05-2000

| Im Recherchenbericht angeführtes Patentdokument | Datum der Veröffentlichung | Mitglied(er) der Patentfamilie | Datum der Veröffentlichung |
|---|---|---|---|
| GB 2236225 A | 27-03-1991 | KEINE | |
| US 4193035 A | 11-03-1980 | DE 2657170 A<br>FR 2374785 A<br>JP 53075813 A | 22-06-1978<br>13-07-1978<br>05-07-1978 |
| US 4607229 A | 19-08-1986 | JP 60132412 A<br>DE 3446268 A<br>NL 8403742 A | 15-07-1985<br>04-07-1985<br>16-07-1985 |
| US 4394626 A | 19-07-1983 | JP 56076637 A | 24-06-1981 |
| DE 19620682 A | 28-11-1996 | GB 2301250 A,B<br>US 5821895 A | 27-11-1996<br>13-10-1998 |

EPO FORM P0461

Für nähere Einzelheiten zu diesem Anhang : siehe Amtsblatt des Europäischen Patentamts, Nr.12/82